# EUROPEAN PATENT APPLICATION

(11) **EP 4 760 778 A1**
(43) Date of publication of application: **17.06.2026**
(21) Application number: 24853597.3
(22) Date of filing: 05.08.2024
(51) Int. Cl.: H01L 21/67

(54) **SEMICONDUCTOR PROCESS APPARATUS AND EXHAUST SYSTEM THEREOF**

(30) Priority: 11.08.2023 CN 202311013258
(71) Applicant: Beijing NAURA Microelectronics Equipment Co., Ltd., Beijing 100176 (CN)
(72) Inventor: WANG, Lika, Beijing 100176 (CN); SHI, Lei, Beijing 100176 (CN); MA, Yongchang, Beijing 100176 (CN)
(74) Representative: Cohausz & Florack
(86) International application number: PCT/CN2024/109737
(87) International publication number: WO 2025/036185

(57) **Abstract**

The present disclosure discloses a semiconductor process apparatus and an exhaust system thereof, and belongs to the field of semiconductor technology. The exhaust system of the semiconductor process apparatus includes a first vacuum pipeline, a second vacuum pipeline, a vacuum proportional valve, and a first pressure detection device, an inlet end of the first vacuum pipeline is configured to be communicated with a reaction chamber, the first pressure detection device is disposed on the first vacuum pipeline to detect a pressure value of the first vacuum pipeline, the vacuum proportional valve is disposed between an outlet end of the first vacuum pipeline and an inlet end of the second vacuum pipeline, an outlet end of the second vacuum pipeline is connected to a vacuum pump, and an opening degree of the vacuum proportional valve is capable of being regulated based on the pressure value detected by the first pressure detection device. Thus, under pumping action of the vacuum pump, a pressure in the reaction chamber can be stably maintained in a high vacuum state through the vacuum proportional valve, highly active free radicals can be generated from hydrogen and oxygen, and an oxide film with high density and high process uniformity can be rapidly formed, thereby improving process effects.

## Description

### TECHNICAL FIELD

The present disclosure belongs to the field of semiconductor technology, and particularly relates to a semiconductor process apparatus and an exhaust system thereof.

### BACKGROUND

In the field of integrated circuit manufacturing, two oxidation techniques are commonly used in an atmospheric pressure or micro-low pressure environment at present. The first one is wet-oxygen oxidation which uses water vapor as an oxidant for reaction, and this technique is high in film forming rate but is low in film density and poor in insulation performance and wafer surface uniformity; and the second one is dry-oxygen oxidation which uses oxygen as an oxidant for reaction, and this technique is high in film density, but is low in film formation rate and poor in uniformity. With the development of process technology, line widths are required to be narrower, and accordingly, oxide films are required to be more uniform and denser, and the film formation rate is required to be higher.

An existing semiconductor process apparatus includes a reaction chamber and an exhaust system communicated with the reaction chamber, and a gas is discharged from the reaction chamber with the exhaust system. However, the existing exhaust system can only maintain the reaction chamber in an atmospheric pressure or micro-low pressure environment, and the oxidation techniques adopted in the atmospheric pressure or micro-low pressure environment produce poor process effects.

### SUMMARY

Embodiments of the present disclosure aim to provide a semiconductor process apparatus and an exhaust system thereof, which can solve the problem of poor process effects of the semiconductor process apparatus in the related technology.

In a first aspect, an embodiment of the present disclosure provides an exhaust system of a semiconductor process apparatus, including a first vacuum pipeline, a second vacuum pipeline, a vacuum pump, a vacuum proportional valve, and a first pressure detection device, an inlet end of the first vacuum pipeline is configured to be communicated with a reaction chamber, the first pressure detection device is disposed on the first vacuum pipeline to detect a pressure value of the first vacuum pipeline, the vacuum proportional valve is disposed between an outlet end of the first vacuum pipeline and an inlet end of the second vacuum pipeline, an outlet end of the second vacuum pipeline is connected to the vacuum pump, and an opening degree of the vacuum proportional valve is capable of being regulated based on the pressure value detected by the first pressure detection device.

In a second aspect, an embodiment of the present disclosure further provides a semiconductor process apparatus, including a reaction chamber and the above exhaust system, and the inlet end of the first vacuum pipeline is communicated with the reaction chamber.

In the embodiments of the present disclosure, the vacuum pump is used to apply pumping action to the reaction chamber through the first vacuum pipeline and the second vacuum pipeline, so as to reduce a pressure value of the reaction chamber. Moreover, the vacuum proportional valve is relatively suitable for a high vacuum environment, and the opening degree of the vacuum proportional valve is regulated based on the pressure value detected by the first pressure detection device. Through the vacuum proportional valve, it can be ensured that the vacuum pump applies a stable suction force to the reaction chamber, and the pressure value detected by the first pressure detection device can be stably maintained in a high vacuum state. The first vacuum pipeline is communicated with the reaction chamber, the pressure value of the first vacuum pipeline is equal to that of the reaction chamber, so that the reaction chamber can be stably maintained in a high vacuum state. Thus, the reaction chamber is maintained in the high vacuum state, highly active free radicals can be generated from hydrogen and oxygen, and an oxide film with high density and high process uniformity can be rapidly formed. Compared with the oxidation techniques adopted in the atmospheric pressure or micro-low pressure environment, the oxidation technology adopted in the high vacuum environment can meet process requirements better and improve process effects.

### BRIEF DESCRIPTION OF DRAWINGS

FIG. 1 is a schematic structural diagram of a semiconductor process apparatus in the related technology; and
FIG. 2 is a schematic structural diagram of a semiconductor process apparatus according to an embodiment of the present disclosure.

### Description of reference numerals:

100'-reaction chamber,
200'-three-way reversing valve,
300'-atmospheric pressure exhaust pipe, 310'-atmospheric pressure control valve,
400'-low pressure exhaust pipe, 410'-low pressure control valve, 420'-differential pressure gauge, 430'-wide-range vacuum gauge, 440'-narrow-range vacuum gauge,
500'-vacuum pump,
100-reaction chamber,
210-first vacuum pipeline, 220-second vacuum pipeline, 221-second pressure detection device, 222-vacuum branch, 223-tenth on-off valve, 230-vacuum proportional valve,
300-vacuum pump,
400-first pressure detection device, 410-first vacuum gauge, 420-second vacuum gauge, 430-differential pressure gauge,
500-slow pumping pipeline, 510-first on-off valve, 520-first restrictor, 530-throttle valve,
610-first pressure relief pipe, 611-second on-off valve, 612-first check valve, 620-second pressure relief pipe, 630-third pressure relief pipe, 631-third on-off valve,
710-first supplementary gas pipeline, 711-fourth on-off valve, 712-pressure regulating valve, 713-flow regulating element, 714-second check valve, 715-pressure detecting element,
720-second supplementary gas pipeline, 721-fifth on-off valve, 722-second restrictor, 723-third check valve,
810-sixth on-off valve, 820-seventh on-off valve, 830-eighth on-off valve, 840-ninth on-off valve,
910-first branch, 920-second branch, 930-third branch.

### DETAIL DESCRIPTION OF EMBODIMENTS

The technical solutions provided in the embodiments of the present disclosure are clearly described below with reference to the drawings for the embodiments of the present disclosure. Apparently, the embodiments described herein are just some embodiments of the present disclosure, and do not cover all embodiments. All other embodiments derived by those of ordinary skill in the art from the embodiments of the present disclosure fall within the scope of the present disclosure.

The terms "first", "second" and the like in the description and the claims of the present disclosure are used for distinguishing between similar objects, but not for describing a particular order or a chronological order. It should be understood that the data such used may be interchanged under appropriate circumstances, so as to allow the embodiments of the present disclosure to be implemented in an order other than those illustrated or described herein; and the objects distinguished by the terms "first", "second" and the like generally belong to one kind, and the number of the objects is not limited, for example, the number of a first object may be one or more. In addition, the term "and/or" in the description and the claims indicates at least one of the objects connected by the term "and/or", and the forward slash "/" generally indicates that the object before "/" and the object after "/" are in an "or" relationship.

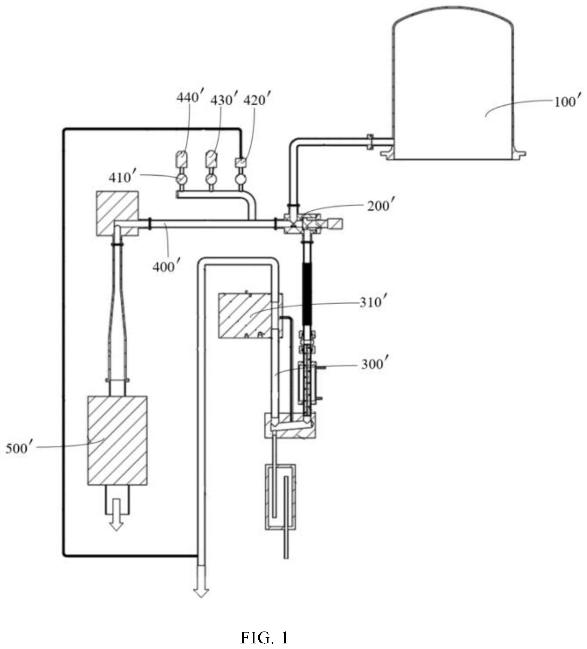

In the related technology, referring to FIG. 1, a semiconductor process apparatus discharges a gas from a reaction chamber 100' through an exhaust system, which is communicated with the reaction chamber 100'. The exhaust system includes a three-way reversing valve 200', an atmospheric pressure exhaust pipe 300', and a low pressure exhaust pipe 400', an inlet end of the three-way reversing valve 200' is communicated with the reaction chamber 100', the three-way reversing valve 200' is provided with an atmospheric pressure gas outlet and a low pressure gas outlet, the atmospheric pressure exhaust pipe 300' is communicated with the atmospheric pressure gas outlet, the atmospheric pressure exhaust pipe 300' is provided with an atmospheric pressure control valve 310', and the reaction chamber 100' may be maintained in an atmospheric pressure environment of 760 Torr with the atmospheric pressure control valve 310'; an inlet end of the low pressure exhaust pipe 400' is communicated with the low pressure gas outlet, an outlet end of the low pressure exhaust pipe 400' is connected to a vacuum pump 500', the low pressure exhaust pipe 400' is provided with a low pressure control valve 410', and the reaction chamber 100' may be maintained in a low pressure environment up to 50 Torr with the low pressure control valve 410' under the suction action of the vacuum pump 500', but the low pressure environment is unstable.

In some embodiments, the low pressure control valve 410' may include a first pneumatic valve, a second pneumatic valve, and a third pneumatic valve, an inlet end of the first pneumatic valve, an inlet end of the second pneumatic valve, and an inlet end of the third pneumatic valve are all communicated with the low pressure exhaust pipe 400', an outlet end of the first pneumatic valve is connected to a differential pressure gauge 420', an outlet end of the second pneumatic valve is connected to a wide-range vacuum gauge 430', and an outlet end of the third pneumatic valve is connected to a narrow-range vacuum gauge 440', with the wide-range vacuum gauge 430' having a range up to 1000 Torr, and the narrow-range vacuum gauge 440' having a range up to 100 Torr. A pressure in the low pressure exhaust pipe 400' is detected with the differential pressure gauge 420', the wide-range vacuum gauge 430', and the narrow-range vacuum gauge 440'.

However, the exhaust system can only maintain the reaction chamber 100' in the atmospheric pressure or micro-low pressure environment, so that only the wet-oxygen oxidation or the dry-oxygen oxidation can be adopted to process a wafer. The wet-oxygen oxidation uses water vapor as an oxidant for reaction, and is high in film forming rate of the wafer but is low in film density and poor in process uniformity of the wafer; and the dry-oxygen oxidation uses oxygen as an oxidant for reaction, and is high in film density, but is low in film formation rate of the wafer and is poor in process uniformity of the wafer. In general, the oxidation techniques adopted in the atmospheric pressure or micro-low pressure environment produces poor process effects.

In view of the above, the present disclosure discloses a semiconductor process apparatus and an exhaust system thereof, which can maintain a reaction chamber in a high vacuum state, and the oxidation technology adopted in a high vacuum environment can effectively improve process effects.

The semiconductor process apparatus and the exhaust system thereof provided in the embodiments of the present disclosure are described in detail in conjunction with exemplary embodiments and application scenarios thereof and with reference to the drawings.

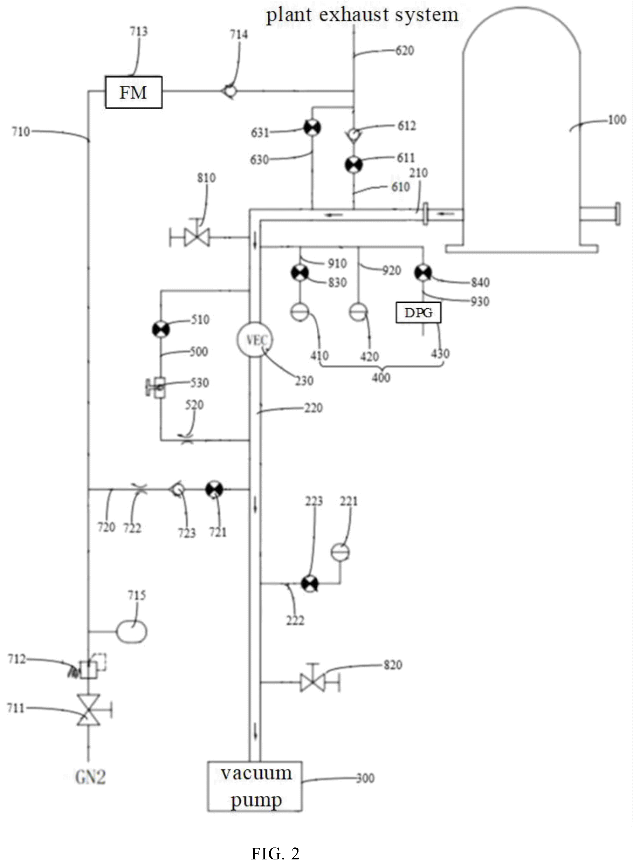

Referring to FIG. 2, an exhaust system of a semiconductor process apparatus according to an embodiment of the present disclosure is configured to evacuate a reaction chamber 100, so as to maintain the reaction chamber 100 in a high vacuum state.

The exhaust system includes a first vacuum pipeline 210, a second vacuum pipeline 220, a vacuum pump 300, a vacuum proportional valve 230, and a first pressure detection device 400, an inlet end of the first vacuum pipeline 210 is configured to be communicated with the reaction chamber 100, the vacuum proportional valve 230 is disposed between an outlet end of the first vacuum pipeline 210 and an inlet end of the second vacuum pipeline 220, that is, a gas inlet of the vacuum proportional valve 230 is connected to the first vacuum pipeline 210, and a gas outlet of the vacuum proportional valve 230 is connected to the second vacuum pipeline 220; moreover, an outlet end of the second vacuum pipeline 220 is connected to the vacuum pump 300. Thus, when the vacuum pump 300 is in operation, the vacuum pump 300 applies pumping action to the reaction chamber 100 through the second vacuum pipeline 220 and the first vacuum pipeline 210, so as to discharge a gas from the reaction chamber 100 and reduce a pressure in the reaction chamber 100. Meanwhile, the vacuum proportional valve 230 is relatively suitable for a high vacuum environment, and is capable of playing a role in stabilization and regulation, and a gas flow rate in the first vacuum pipeline 210 and that in the second vacuum pipeline 220 can be regulated with the vacuum proportional valve 230 to stably maintain the pressure in the reaction chamber 100 in a high vacuum state. In some embodiments, the pressure in the reaction chamber 100 may be stably maintained at 1 mTorr.

The first pressure detection device 400 is disposed on the first vacuum pipeline 210, and is configured to detect a pressure value of the first vacuum pipeline 210, and the first pressure detection device 400 may be a pressure gauge or other elements capable of detecting pressure. An opening degree of the vacuum proportional valve 230 may be regulated based on the pressure value detected by the first pressure detection device 400. In some embodiments, the exhaust system may regulate the opening degree of the vacuum proportional valve 230 based on the pressure value detected by the first pressure detection device 400. Further, in some embodiments, the exhaust system may include a control device, which is communicatively connected to the first pressure detection device 400 and the vacuum proportional valve 230 respectively, and the control device automatically regulates the opening degree of the vacuum proportional valve 230 based on the pressure value detected by the first pressure detection device 400. Alternatively, the opening degree of the vacuum proportional valve 230 may be manually regulated based on the pressure value detected by the first pressure detection device 400.

In the embodiments of the present disclosure, the vacuum pump 300 applies the pumping action to the reaction chamber 100 to reduce a pressure value of the reaction chamber 100. Moreover, the vacuum proportional valve 230 is relatively suitable for the high vacuum environment, and can perform stable and accurate regulation in the high vacuum environment. Therefore, through the vacuum proportional valve 230, it can be ensured that the vacuum pump 300 applies a stable suction force to the reaction chamber 100, and the pressure value detected by the first pressure detection device 400 can be stably maintained in a high vacuum state, that is, the pressure in the reaction chamber 100 is stably maintained in the high vacuum state. Thus, the reaction chamber 100 is maintained in the high vacuum state, highly active free radicals can be generated from hydrogen and oxygen, and an oxide film with high density and high process uniformity can be rapidly formed. Compared with the oxidation techniques adopted in the atmospheric pressure or micro-low pressure environment, the oxidation technology adopted in the high vacuum environment can meet process requirements better and improve process effects.

In an initial stage of pumping a gas out of the reaction chamber 100 with the vacuum pump 300, the vacuum proportional valve 230 is opened, the pumped gas passes through the first vacuum pipeline 210, the vacuum proportional valve 230, and the second vacuum pipeline 220 in sequence, the pressure in the reaction chamber 100 drops rapidly and is accompanied by severe pressure fluctuation, which may cause vibration of a wafer in the reaction chamber 100 and further cause breakage of the wafer.

In order to solve the above problem, the exhaust system further includes a slow pumping pipeline 500, a first on-off valve 510, and a flow limiting device, a first end of the slow pumping pipeline 500 is communicated with the first vacuum pipeline 210, a second end of the slow pumping pipeline 500 is communicated with the second vacuum pipeline 220, the flow limiting device and the first on-off valve 510 are both disposed on the slow pumping pipeline 500, the first on-off valve 510 is configured to control on and off of the slow pumping pipeline 500, the flow limiting device is configured to control a gas flow rate in the slow pumping pipeline 500, and the flow limiting device is connected in series with the first on-off valve 510, and is connected in parallel with the vacuum proportional valve 230. Exemplarily, the slow pumping pipeline 500 includes a first slow pumping section and a second slow pumping section, the first on-off valve 510 is disposed between the first slow pumping section and the second slow pumping section, the first slow pumping section is communicated with the first vacuum pipeline 210, the second slow pumping section is communicated with the second vacuum pipeline 220, and the flow limiting device is disposed on the second slow pumping section. In some embodiments, the first on-off valve 510 may be a pneumatic valve or other on-off valves that perform opening and closing functions.

By adopting the present embodiment, in the initial stage of pumping the gas out of the reaction chamber 100 with the vacuum pump 300, the vacuum proportional valve 230 is closed, and the first on-off valve 510 is opened, so that the pumped gas can pass through the first vacuum pipeline 210, the slow pumping pipeline 500, and the second vacuum pipeline 220 in sequence. A pumping speed is controlled to be relatively low by the flow limiting device, so that the pressure in the reaction chamber 100 can transition smoothly from atmospheric pressure to a low pressure, the vibration or even breakage of the wafer caused by the severe pressure fluctuation due to the high pumping speed can be avoided, and process effects can be ensured.

In some embodiments, the flow limiting device may only include a throttle valve 530, and a gas flow range of a gas flowing through the slow pumping pipeline 500 may be controlled by regulating the throttle valve 530. Further, in some embodiments, the throttle valve 530 may be a needle valve. In other embodiments, the flow limiting device may further include a first restrictor 520, which is connected in series with the throttle valve 530, and is configured to limit a maximum gas flow of the gas flowing through the slow pumping pipeline 500. It should be noted that the maximum gas flow limited by the first restrictor 520 is less than a maximum value of the gas flow range capable of being controlled by the throttle valve 530. By adopting the present embodiment, the combination of the throttle valve 530 and the first restrictor 520 can limit both the gas flow range and the maximum gas flow of the gas flowing through the slow pumping pipeline 500, avoid the phenomenon that a gas flow of the gas flowing through the slow pumping pipeline 500 is relatively large when using the throttle valve 530 alone, effectively reduce the gas flow in the slow pumping pipeline 500, and reduce the pumping speed to facilitate the smooth transition of the pressure in the reaction chamber 100 from atmospheric pressure to the low pressure.

When the reaction chamber 100 is in a vacuum state, after a process is completed, the pressure in the reaction chamber 100 needs to be restored to atmospheric pressure. At this time, the vacuum proportional valve 230 is closed, and a gas such as nitrogen is introduced into the reaction chamber 100 to increase the pressure in the reaction chamber 100. However, there are cases where the pressure in the reaction chamber 100 is higher than atmospheric pressure due to abnormal gas introduction.

In order to solve the above problem, the exhaust system further includes a first pressure relief pipe 610, a second pressure relief pipe 620, and a second on-off valve 611, an inlet end of the first pressure relief pipe 610 is communicated with the first vacuum pipeline 210, an outlet end of the first pressure relief pipe 610 is communicated with the second pressure relief pipe 620, the second on-off valve 611 is disposed between the first pressure relief pipe 610 and the second pressure relief pipe 620, that is, the outlet end of the first pressure relief pipe 610 is connected to an inlet end of the second on-off valve 611, an inlet end of the second pressure relief pipe 620 is connected to an outlet end of the second on-off valve 611, the second pressure relief pipe 620 may be connected to a plant exhaust system, and whether the first pressure relief pipe 610 is communicated with the second pressure relief pipe 620 may be controlled by the second on-off valve 611. In a case where the pressure value detected by the first pressure detection device 400 reaches a first pressure value, which indicates that the pressure in the reaction chamber 100 is too high, the second on-off valve 611 is open to enable a gas in the reaction chamber 100 to be discharged through the first vacuum pipeline 210, the first pressure relief pipe 610, and the second pressure relief pipe 620 in sequence, thereby rapidly reducing the pressure in the reaction chamber 100. The first pressure value is greater than an atmospheric pressure value. Similarly, in a case where the pressure value detected by the first pressure detection device 400 reaches the atmospheric pressure value, which indicates that the pressure in the reaction chamber 100 is restored to atmospheric pressure at this time, gas discharging does not need to be continued, so that the second on-off valve 611 is closed. By adopting the present embodiment, pressure relief can be rapidly achieved when the reaction chamber 100 is overpressurized, and safety of the semiconductor process apparatus can be ensured.

In some embodiments, the second on-off valve 611 may be a pneumatic valve or other on-off valves that perform opening and closing functions; and the second on-off valve 611 may be communicatively connected to the first pressure detection device 400, and in a case where the pressure value detected by the first pressure detection device 400 reaches the first pressure value, the second on-off valve 611 is automatically opened. Certainly, the second on-off valve 611 may be manually controlled based on the pressure value detected by the first pressure detection device 400.

Certainly, in other embodiments, the exhaust system may not be provided with the first pressure relief pipe 610, the second pressure relief pipe 620, or the second on-off valve 611, and gas discharging may be performed with other methods in the case of overpressure, for example, the reaction chamber 100 is directly provided with a pressure relief device.

When the reaction chamber 100 is overpressurized, the second on-off valve 611 is in an open state, but if the first pressure relief pipe 610 is blocked or the second on-off valve 611 malfunctions, the gas in the reaction chamber 100 cannot be discharged through the first pressure relief pipe 610 and the second pressure relief pipe 620, pressure relief cannot be performed timely, and the reaction chamber 100 may have a problem due to long-time overpressure.

In order to solve the above problem, the exhaust system further includes a third pressure relief pipe 630 and a third on-off valve 631, an inlet end of the third pressure relief pipe 630 is communicated with the first vacuum pipeline 210, an outlet end of the third pressure relief pipe 630 is communicated with the second pressure relief pipe 620, and the third on-off valve 631 is disposed on the third pressure relief pipe 630, that is, the third pressure relief pipe 630 is connected in parallel with the first pressure relief pipe 610. When the first pressure relief pipe 610 fails to discharge the gas, gas discharging for pressure relief may be performed with the third pressure relief pipe 630. At this time, the gas is discharged after sequentially flowing through the first vacuum pipeline 210, the third pressure relief pipe 630, and the second pressure relief pipe 620. In some embodiments, in a case where the pressure value detected by the first pressure detection device 400 reaches the first pressure value and the second on-off valve 611 is in a closed state, which indicates that the reaction chamber 100 is overpressurized and the second on-off valve 611 malfunctions, the third on-off valve 631 is in an open state at this time, and gas discharging for pressure relief is performed through the third pressure relief pipe 630. Certainly, when the first pressure relief pipe 610 fails to discharge the gas, a flow in the first pressure relief pipe 610 is relatively small, the flow in the first pressure relief pipe 610 may be detected with a flow detection element, and the third on-off valve 631 is in an open state when the pressure value detected by the first pressure detection device 400 reaches the first pressure value and the flow in the first pressure relief pipe 610 is relatively small.

By adopting the present embodiment, when the first pressure relief pipe 610 fails to discharge the gas for pressure relief, the third on-off valve 631 is opened to conduct the third pressure relief pipe 630, and the third pressure relief pipe 630 is used to discharge the gas for pressure relief. Thus, a two-stage pressure relief pipeline is provided for high safety, and can ensure timely gas discharging and pressure relief of the reaction chamber 100, and ensure that the semiconductor process apparatus is in a safe state.

In some embodiments, the third on-off valve 631 may be a pneumatic valve or other on-off valves that perform opening and closing functions; the third on-off valve 631 is communicatively connected to the second on-off valve 611 and the first pressure detection device 400 (or a flow detection element) respectively; and in a case where the pressure value detected by the first pressure detection device 400 reaches the first pressure value and the second on-off valve 611 is in a closed state (or the flow in the first pressure relief pipe 610 is relatively small), the third on-off valve 631 is automatically opened. Certainly, the third on-off valve 631 may be manually controlled based on the pressure value detected by the first pressure detection device 400 and an open/close state of the second on-off valve 611 (or a flow value of the first pressure relief pipe 610 which is detected by the flow detection element).

In some embodiments, the exhaust system further includes a first check valve 612 disposed on the second pressure relief pipe 620, and the first check valve 612 conducts the second pressure relief pipe 620 along a direction from the inlet end of the second pressure relief pipe 620 to an outlet end of the second pressure relief pipe 620. Further, in some embodiments, the first check valve 612 is disposed between the second pressure relief pipe 620 and the second on-off valve 611. By adopting the present embodiment, a gas flow direction in the second pressure relief pipe 620 is restricted with the first check valve 612, so that an external gas is prevented from flowing back into the second pressure relief pipe 620 from the outlet end of the second pressure relief pipe 620, which avoids affecting an exhaust effect. Certainly, in other embodiments, the second pressure relief pipe 620 may not be provided with the first check valve 612.

The outlet end of the second pressure relief pipe 620 is connected to the plant exhaust system, and there are many pollutants inside the plant exhaust system. When the first pressure relief pipe 610 and the second pressure relief pipe 620 do not discharge the gas, the pollutants inside the plant exhaust system may diffuse to the second pressure relief pipe 620, causing blockage of the pipe over time and affecting a pressure relief and gas discharging function.

In order to solve the above problem, the exhaust system further includes a first supplementary gas pipeline 710 and a fourth on-off valve 711, an inlet end of the first supplementary gas pipeline 710 is configured to introduce a purge gas, which may be nitrogen or other gases capable of performing purging. An outlet end of the first supplementary gas pipeline 710 is communicated with the second pressure relief pipe 620, so as to enable the purge gas to blow the second pressure relief pipe 620. The fourth on-off valve 711 is disposed on the first supplementary gas pipeline 710, and controls on or off of the first supplementary gas pipeline 710. Further, in some embodiments, the fourth on-off valve 711 may be a manual valve which is opened or closed manually, and the fourth on-off valve 711 may also be other on-off valves that perform opening and closing functions. By adopting the present embodiment, in a case where the pollutants diffuse to the second pressure relief pipe 620, the fourth on-off valve 711 may be opened, so that the purge gas can blow the second pressure relief pipe 620 through the first supplementary gas pipeline 710 to gradually blow the pollutants out of the second pressure relief pipe 620, thereby preventing the pollutants from blocking the second pressure relief pipe 620, and ensuring that the second pressure relief pipe 620 is unblocked and the exhaust system can perform pressure relief and gas discharging normally.

In some embodiments, the exhaust system further includes at least one of a pressure regulating valve 712 or a flow regulating element 713, and the at least one of the pressure regulating valve 712 or the flow regulating element 713 is disposed on the first supplementary gas pipeline 710. Further, in some embodiments, only the pressure regulating valve 712 is disposed on the first supplementary gas pipeline 710, or only the flow regulating element 713 is disposed on the first supplementary gas pipeline 710, or the pressure regulating valve 712 and the flow regulating element 713 may both be disposed on the first supplementary gas pipeline 710, that is, the pressure regulating valve 712 and the flow regulating element 713 are connected in series, the pressure regulating valve 712 may regulate a pressure value of the first supplementary gas pipeline 710 to be within a first pressure range, and the flow regulating element 713 may regulate a flow in the first supplementary gas pipeline 710 to be within a first flow range. In addition, in some embodiments, the exhaust system further includes a pressure detecting element 715, which is disposed on the first supplementary gas pipeline 710 to detect the pressure value of the first supplementary gas pipeline 710. An opening degree of the pressure regulating valve 712 may be regulated based on the pressure value detected by the pressure detecting element 715, for example, a pressure in the first supplementary gas pipeline 710 is maintained at 0.4 MPa to 0.6 MPa; and the flow regulating element 713 may include a flowmeter (FM), and the flow regulating element 713 performs regulation based on a flow value displayed by the flowmeter to regulate the flow in the first supplementary gas pipeline 710 to about 0.51 L.

By adopting the present embodiment, the pressure in the first supplementary gas pipeline 710 can be maintained within a relatively small range through the pressure regulating valve 712, and the flow in the first supplementary gas pipeline 710 can be maintained within a relatively small flow range through the flow regulating element 713, so that the purge gas can stably blow the second pressure relief pipe 620, and a pressure relief problem of the purge gas caused by an excessive flow and/or an excessive pressure of the purge gas can be avoided.

Certainly, in other embodiments, the first supplementary gas pipeline 710 may not be provided with the pressure regulating valve 712 and/or the flow regulating element 713.

In some embodiments, the exhaust system further includes a second check valve 714 disposed on the first supplementary gas pipeline 710, and the second check valve 714 conducts the first supplementary gas pipeline 710 along a direction from the inlet end of the first supplementary gas pipeline 710 to the outlet end of the first supplementary gas pipeline 710. By adopting the present embodiment, a gas flow direction in the first supplementary gas pipeline 710 is restricted with the second check valve 714, so that the gas in the second pressure relief pipe 620 is prevented from flowing back into the first supplementary gas pipeline 710 from the outlet end of the first supplementary gas pipeline 710, which avoids affecting a purge effect. Certainly, in other embodiments, the first supplementary gas pipeline 710 may not be provided with the second check valve 714.

In a process of applying the pumping action to the reaction chamber 100 by the vacuum pump 300, if the vacuum proportional valve 230 fails or malfunctions, the vacuum proportional valve 230 needs to be detached for maintenance. At this time, the second vacuum pipeline 220 is in a vacuum state, and in order to ensure equipment safety, a pressure in the second vacuum pipeline 220 needs to be restored to atmospheric pressure before detaching the vacuum proportional valve 230. In order to restore the pressure in the second vacuum pipeline 220 to atmospheric pressure, in some embodiments, the exhaust system further includes a second supplementary gas pipeline 720, a fifth on-off valve 721, and a second pressure detection device 221, an inlet end of the second supplementary gas pipeline 720 is configured to introduce a gas, an outlet end of the second supplementary gas pipeline 720 is communicated with the second vacuum pipeline 220, the fifth on-off valve 721 is disposed on the second supplementary gas pipeline 720, the second pressure detection device 221 is disposed on the second vacuum pipeline 220 to detect a pressure value of the second vacuum pipeline 220, and a state of the fifth on-off valve 721 changes based on the pressure value detected by the second pressure detection device 221 to use the second supplementary gas pipeline 720 to supplement the second vacuum pipeline 220 with a gas, so as to restore the pressure in the second vacuum pipeline 220 to atmospheric pressure. The fifth on-off valve 721 may be a pneumatic valve or other on-off valves that perform opening and closing functions. The second pressure detection device 221 may be a pressure gauge, a vacuum gauge, or other elements capable of detecting pressure. Further, in some embodiments, the second pressure detection device 221 may be a vacuum gauge with a range of 0 to 1000 Torr. By adopting the present embodiment, the second supplementary gas pipeline 720 is used to supplement the second vacuum pipeline 220 with the gas to restore the pressure in the second vacuum pipeline 220 to atmospheric pressure, so as to facilitate detachment of the vacuum proportional valve 230, and ensure the equipment safety.

In addition, in some embodiments, the second pressure detection device 221 may be communicatively connected to the fifth on-off valve 721, and in a case where the pressure detected by the second pressure detection device 221 reaches the atmospheric pressure value, the fifth on-off valve 721 is automatically closed, and the second supplementary gas pipeline 720 stops introducing the gas into the second vacuum pipeline 220. Certainly, the fifth on-off valve 721 may be manually controlled based on the pressure value detected by the second pressure detection device 221.

In some embodiments, the exhaust system further includes a second restrictor 722 disposed on the second supplementary gas pipeline 720. Thus, a maximum gas flow in the second supplementary gas pipeline 720 is controlled by the second restrictor 722, so as to avoid the second vacuum pipeline 220 from being overpressurized due to an excessive gas intake speed of the second supplementary gas pipeline 720. Certainly, in other embodiments, the second supplementary gas pipeline 720 may not be provided with the second restrictor 722, and a gas intake flow at the inlet end of the second supplementary gas pipeline 720 is controlled to control a gas flow in the second supplementary gas pipeline 720.

In some embodiments, the exhaust system further includes a third check valve 723 disposed on the second supplementary gas pipeline 720, and the third check valve 723 conducts the second supplementary gas pipeline 720 along a direction from the inlet end of the second supplementary gas pipeline 720 to the outlet end of the second supplementary gas pipeline 720. Thus, a gas flow direction in the second supplementary gas pipeline 720 is restricted with the third check valve 723, so that the gas in the second supplementary gas pipeline 720 is prevented from flowing back into the second supplementary gas pipeline 720 from the outlet end of the second supplementary gas pipeline 720, which avoids affecting a pressurizing effect of the second vacuum pipeline 220. Certainly, in other embodiments, the second supplementary gas pipeline 720 may not be provided with the third check valve 723.

In some embodiments, the exhaust system further includes a vacuum branch 222 and a tenth on-off valve 223, a first end of the vacuum branch 222 is communicated with the second vacuum pipeline 220, the second pressure detection device 221 is connected to a second end of the vacuum branch 222, and the tenth on-off valve 223 is disposed on the vacuum branch 222. Further, in some embodiments, the tenth on-off valve 223 may be a pneumatic valve or other on-off valves that perform opening and closing functions. When the vacuum proportional valve 230 malfunctions, the tenth on-off valve 223 is opened, the second pressure detection device 221 detects the pressure in the second vacuum pipeline 220, then the fifth on-off valve 721 is opened, the second supplementary gas pipeline 720 starts supplementing the second vacuum pipeline 220 with a gas, and the pressure in the second vacuum pipeline 220 gradually rises. In a case where the pressure value detected by the second pressure detection device 221 is within a range of 758 Torr to 762 Torr, which indicates that the second vacuum pipeline 220 is restored to an atmospheric pressure state, the fifth on-off valve 721 is closed to stop the gas supplementing. At this time, the vacuum proportional valve 230 may be safely detached.

In some embodiments, as shown in FIG. 2, the inlet end of the second supplementary gas pipeline 720 is communicated with the first supplementary gas pipeline 710, that is, the first supplementary gas pipeline 710 and the second supplementary gas pipeline 720 may share a same gas source (i.e., GN2). Thus, while nitrogen is introduced into the first supplementary gas pipeline 710, nitrogen may flow through the second supplementary gas pipeline 720. At this time, nitrogen not only serves as a purge gas but also can be used to increase the pressure in the second vacuum pipeline 220. Further, in some embodiments, a connection between the second supplementary gas pipeline 720 and the first supplementary gas pipeline 710 is between the pressure regulating valve 712 and the outlet end of the first supplementary gas pipeline 710.

In some embodiments, the exhaust system further includes a sixth on-off valve 810, an inlet end of the sixth on-off valve 810 is configured to be connected to a first seal detection device, and an outlet end of the sixth on-off valve 810 is connected to the first vacuum pipeline 210. Further, in some embodiments, the sixth on-off valve 810 may be a manual valve or other on-off valves that perform opening and closing functions; and the first seal detection device may be a helium mass spectrometer. By adopting the present embodiment, the inlet end of the sixth on-off valve 810 serves as a seal detection port, and after equipment installation is completed, the inlet end of the sixth on-off valve 810 may be connected to the first seal detection device, so as to detect sealing performance of the first vacuum pipeline 210 with the first seal detection device.

In some embodiments, the exhaust system further includes a seventh on-off valve 820, an inlet end of the seventh on-off valve 820 is configured to be connected to a second seal detection device, and an outlet end of the seventh on-off valve 820 is connected to the second vacuum pipeline 220. Further, in some embodiments, the seventh on-off valve 820 may be a manual valve or other on-off valves that perform opening and closing functions; and the second seal detection device may be a helium mass spectrometer. By adopting the present embodiment, the inlet end of the seventh on-off valve 820 serves as a seal detection port, and after the equipment installation is completed, the inlet end of the seventh on-off valve 820 may be connected to the second seal detection device, so as to detect sealing performance of the second vacuum pipeline 220 with the second seal detection device.

Certainly, in other embodiments, the exhaust system may not be provided with the sixth on-off valve 810 and/or the seventh on-off valve 820, and seal detection is performed on the first vacuum pipeline 210 and the second vacuum pipeline 220 before the equipment installation, with no need for connection with the first seal detection device and/or the second seal detection device for seal detection.

In some embodiments, the first pressure detection device 400 includes a second vacuum gauge 420 with a range of 0 to 1000 Torr; and the exhaust system further includes a second branch 920, a first end of the second branch 920 is communicated with the first vacuum pipeline 210, and a second end of the second branch 920 is connected to the second vacuum gauge 420. Thus, the second vacuum gauge 420 detects a pressure in the second branch 920 to detect the pressure value of the first vacuum pipeline 210. Moreover, due to the wide range of the second vacuum gauge 420, a pressure value of the reaction chamber 100 in a vacuum state and that in an atmospheric pressure state can be effectively measured, but the second vacuum gauge 420 has low detection accuracy.

In other embodiments, the first pressure detection device 400 further includes a first vacuum gauge 410 with a range narrower than that of the second vacuum gauge 420; and the exhaust system further includes a first branch 910 and an eighth on-off valve 830, a first end of the first branch 910 is communicated with the first vacuum pipeline 210, a second end of the first branch 910 is connected to the first vacuum gauge 410, and the eighth on-off valve 830 is disposed on the first branch 910, and controls on or off of the first branch 910. Further, in some embodiments, the eighth on-off valve 830 may be a pneumatic valve or other on-off valves that perform opening and closing functions. In a case where the pressure value detected by the second vacuum gauge 420 is greater than a second pressure value, the eighth on-off valve 830 is in a closed state. At this time, the second vacuum gauge 420 effectively measures pressure values (10 Torr to 760 Torr) of the first vacuum pipeline 210, i.e., pressure values of the reaction chamber 100, in a medium vacuum state, in a low vacuum state, and in an atmospheric pressure state; and in a case where the pressure value detected by the second vacuum gauge 420 is less than or equal to the second pressure value, the eighth on-off valve 830 is in an open state, the first vacuum gauge 410 accurately measures and feeds back the pressure value of the first vacuum pipeline 210, i.e., a pressure value of the reaction chamber 100, under the condition of high vacuum (1 mTorr to 10 Torr). The second pressure value is a maximum pressure value in a high vacuum state. In some embodiments, the second pressure value is 10 Torr, and the range of the first vacuum gauge 410 may be 0 to 10 Tor. In a case where the pressure value detected by the second vacuum gauge 420 is greater than 10 Torr, which indicates that the pressure in the second vacuum pipeline 220 exceeds the maximum pressure value in the high vacuum state, it is not necessary to accurately detect the pressure value of the reaction chamber 100 at this time. Meanwhile, in order to avoid damaging the first vacuum gauge 410, the eighth on-off valve 830 is closed, the first vacuum gauge 410 does not perform pressure detection, and only the second vacuum gauge 420 performs pressure detection.

By adopting the present embodiment, in a case where the reaction chamber 100 is in the high vacuum state, the pressure in the reaction chamber 100 is relatively low, the pressure value of the reaction chamber 100 in the high vacuum state is accurately detected with the first vacuum gauge 410, and high detection accuracy can be achieved; and in a case where the reaction chamber 100 is in the medium vacuum state, the low vacuum state, or the atmospheric pressure state, the pressure in the reaction chamber 100 is relatively high, the pressure value of the reaction chamber 100 is effectively detected with the second vacuum gauge 420, and meanwhile, the eighth on-off valve 830 is set to avoid damaging the first vacuum gauge 410 due to over-range detection.

In some embodiments, the first pressure detection device 400 further includes a differential pressure gauge (DPG) 430, the exhaust system further includes a third branch 930 and a ninth on-off valve 840, a first end of the third branch 930 is communicated with the first vacuum pipeline 210, a second end of the third branch 930 is connected to a first end of the differential pressure gauge 430, a second end of the differential pressure gauge 430 is communicated with the external atmosphere, and the ninth on-off valve 840 is disposed on the third branch 930, and controls on and off of the third branch 930. In a case where a difference between the pressure value detected by the second vacuum gauge 420 and the atmospheric pressure value is less than a first difference, which indicates that the pressure value of the reaction chamber 100 is close to the atmospheric pressure value, the ninth on-off valve 840 is in an open state, the third branch 930 is opened, the differential pressure gauge 430 starts to detect the difference between the pressure value of the second vacuum pipeline 220 and the atmospheric pressure value. At this time, the opening degree of the vacuum proportional valve 230 is regulated based on a differential pressure value of the differential pressure gauge 430 until the differential pressure value of the differential pressure gauge 430 is zero, that is, the pressure value of the reaction chamber 100 is restored to the atmospheric pressure value. Due to different environments in different regions, some regions have lower pressures while other regions have higher pressures, so the atmospheric pressure state does not correspond to 760 Torr. If the reaction chamber 100 is restored to 760 Torr only based on the pressure value detected by the second vacuum gauge 420, the pressure value of the reaction chamber 100 does not reach the atmospheric pressure value. Therefore, according to the differential pressure gauge 430, the opening degree of the vacuum proportional valve 230 is regulated based on the difference between the pressure value of the reaction chamber 100 and the atmospheric pressure value, so as to ensure that the pressure value of the reaction chamber 100 is accurately restored to the atmospheric pressure value.

Certainly, in other embodiments, the first pressure detection device 400 may not be provided with the differential pressure gauge 430, and the opening degree of the vacuum proportional valve 230 is regulated based on the pressure value detected by the second vacuum gauge 420 until the pressure value detected by the second vacuum gauge 420 reaches 760 Torr.

In summary, an operating flow of the exhaust system of the semiconductor process apparatus disclosed in the embodiments of the present disclosure is described below.

After the equipment installation is completed, the sealing performance of the first vacuum pipeline 210 and that of the second vacuum pipeline 220 are detected first. Exemplarily, when detecting the sealing performance of the first vacuum pipeline 210, the vacuum proportional valve 230 is closed, the first seal detection device such as a helium mass spectrometer is connected to the inlet end of the sixth on-off valve 810, and the eighth on-off valve 830, the ninth on-off valve 840, the first on-off valve 510, the second on-off valve 611, and the third on-off valve 631 are closed, so as to make the first vacuum pipeline 210 in a closed state; then the sixth on-off valve 810 is opened, and the first seal detection device is turned on to detect a leakage rate of the first vacuum pipeline 210. If the leakage rate meets a set standard, which indicates that the sealing performance of the first vacuum pipeline 210 is qualified, the sixth on-off valve 810 is closed, the first seal detection device is detached; and if the leakage rate does not meet the set standard, installation needs to be performed again to ensure the sealing performance.

When detecting the sealing performance of the second vacuum pipeline 220, the vacuum proportional valve 230 is closed, the second seal detection device such as a helium mass spectrometer is connected to the inlet end of the seventh on-off valve 820, the tenth on-off valve 223, the first on-off valve 510, and the fifth on-off valve 721 are closed, and the vacuum pump 300 is turned off, so as to make the second vacuum pipeline 220 in a closed state; then the seventh on-off valve 820 is opened, and the second seal detection device is turned on to detect a leakage rate of the second vacuum pipeline 220. If the leakage rate meets a set standard, which indicates that the sealing performance of the second vacuum pipeline 220 is qualified, the seventh on-off valve 820 is closed, and the second seal detection device is detached; and if the leakage rate does not meet the set standard, installation needs to be performed again to ensure the sealing performance.

After passing the seal detection of the first vacuum pipeline 210 and the seal detection of the second vacuum pipeline 220, process steps may be performed. At this time, the sixth on-off valve 810, the seventh on-off valve 820, the eighth on-off valve 830, the ninth on-off valve 840, the second on-off valve 611, the third on-off valve 631, and the tenth on-off valve 223 are closed. In the initial stage of pumping the gas out of the reaction chamber 100 with the vacuum pump 300, the pressure in the reaction chamber 100 drops rapidly, which can easily cause the vibration of the wafer in the reaction chamber 100. Therefore, the vacuum proportional valve 230 is closed first, the first on-off valve 510 is opened, and an opening degree of the throttle valve 530 is regulated to be relatively small. Meanwhile, the maximum gas flow in the slow pumping pipeline 500 is limited with the first restrictor 520, and then the vacuum pump 300 is turned on again. At this time, the gas in the reaction chamber 100 sequentially passes through the first vacuum pipeline 210, the slow pumping pipeline 500, the second vacuum pipeline 220, and the vacuum pump 300, and the pressure in the reaction chamber 100 gradually drops. In this process, the second vacuum gauge 420 detects the pressure in the reaction chamber 100 in real time. After stable transition of the pressure, the pressure in the reaction chamber 100 does not fluctuate violently, and starts to drop uniformly. At this time, the first on-off valve 510 is closed, the vacuum proportional valve 230 is opened, and instead of passing through the slow pumping pipeline 500, the gas sequentially passes through the first vacuum pipeline 210, the second vacuum pipeline 220, and the vacuum pump 300. When the pressure value of the reaction chamber 100 is reduced to be less than 10 Torr, the eighth on-off valve 830 is opened. At this time, the first vacuum gauge 410 accurately measures the pressure value of the reaction chamber 100, and simultaneously transmits the detected pressure value to the vacuum proportional valve 230, and the opening degree of the vacuum proportional valve 230 is regulated based on the pressure value, so as to stably maintain the pressure in the reaction chamber 100 at 1mTorr, thereby providing a high vacuum condition for a subsequent oxidation process in the reaction chamber 100.

After the oxidation process is completed, the pressure in the reaction chamber 100 needs to be restored to atmospheric pressure. At this time, the vacuum proportional valve 230 and the eighth on-off valve 830 are closed to avoid damaging the first vacuum gauge 410 due to over-range of the pressure, the reaction chamber 100 is continuously supplemented with nitrogen, the second vacuum gauge 420 detects the pressure in real time, and the ninth on-off valve 840 is opened when the pressure value is restored to 720 Torr. At this time, the differential pressure gauge 430 compares the difference between the pressure in the reaction chamber 100 and atmospheric pressure in real time. When the difference from the differential pressure gauge 430 is zero, which indicates that the reaction chamber 100 is restored to the atmospheric pressure state, supplementing the reaction chamber 100 with nitrogen is stopped.

If the difference from the differential pressure gauge 430 keeps being greater than zero due to the abnormal gas introduction into the reaction chamber 100, it is indicated that the pressure in the reaction chamber 100 exceeds atmospheric pressure. When the difference reaches a first set value such as 20 Torr, the second on-off valve 611 is opened, the first check valve 612 is synchronously opened, and nitrogen in the reaction chamber 100 is discharged into the plant exhaust system through the first pressure relief pipe 610 and the second pressure relief pipe 620, so as to timely relieve the pressure in the reaction chamber 100, and reduce the pressure in the reaction chamber 100 to atmospheric pressure. If the first pressure relief pipe 610 malfunctions and cannot perform pressure relief, the difference from the differential pressure gauge 430 keeps rising. When the difference reaches a second set value such as 25 Torr, the third on-off valve 631 is opened, and nitrogen in the reaction chamber 100 is discharged into the plant exhaust system through the third pressure relief pipe 630 and the second pressure relief pipe 620, so as to ensure successful pressure relief of the reaction chamber 100, and ensure the equipment safety.

In addition, when the pollutants inside the plant exhaust system diffuse to the second pressure relief pipe 620 to cause the blockage, the pressure relief and gas discharging function is affected. At this time, the fourth on-off valve 711 is opened, the purge gas enters the second pressure relief pipe 620 through the first supplementary gas pipeline 710, and the purge gas blows the second pressure relief pipe 620 to gradually blow the pollutants out of the second pressure relief pipe 620, thereby ensuring that the second pressure relief pipe 620 is unblocked.

In the process of pumping the reaction chamber 100 with the vacuum pump 300, if the vacuum proportional valve 230 fails or malfunctions, the vacuum proportional valve 230 needs to be detached for maintenance. At this time, the second vacuum pipeline 220 is in a vacuum state, and the vacuum proportional valve 230 cannot be directly detached. In order to ensure the equipment safety, the fifth on-off valve 721 and the tenth on-off valve 223 are opened, the second supplementary gas pipeline 720 supplements the second vacuum pipeline 220 with nitrogen. Meanwhile, the second pressure detection device 221 detects the pressure value of the second vacuum pipeline 220. When the pressure value of the second vacuum pipeline 220 reaches the atmospheric pressure value, the fifth on-off valve 721 is closed, nitrogen supplementation is stopped, and the vacuum proportional valve 230 may be safely detached at this time.

Based on the exhaust system disclosed in the embodiments of the present disclosure, an embodiment of the present disclosure further provides a semiconductor process apparatus, which includes a reaction chamber 100 and the exhaust system described in the above embodiments, with the inlet end of the first vacuum pipeline 210 being communicated with the reaction chamber 100. In some embodiments, the semiconductor process apparatus may be vertical furnace equipment provided with a reaction chamber 100 configured to perform a high-vacuum oxidation process.

The embodiments of the present disclosure are described above with reference to the drawings, but the present disclosure is not limited to the above specific implementations which are just for illustration rather than for limitation. Enlightened by the present disclosure, those of ordinary skill in the art can make many variations without departing from the spirit of the present disclosure and the scope of the claims, and all those variations should be considered to fall within the scope of the present disclosure.

## Claims

1. An exhaust system of a semiconductor process apparatus, comprising a first vacuum pipeline, a second vacuum pipeline, a vacuum pump, a vacuum proportional valve, and a first pressure detection device, wherein an inlet end of the first vacuum pipeline is configured to be communicated with a reaction chamber, the first pressure detection device is disposed on the first vacuum pipeline to detect a pressure value of the first vacuum pipeline, the vacuum proportional valve is disposed between an outlet end of the first vacuum pipeline and an inlet end of the second vacuum pipeline, an outlet end of the second vacuum pipeline is connected to the vacuum pump, and an opening degree of the vacuum proportional valve is capable of being regulated based on the pressure value detected by the first pressure detection device.

2. The exhaust system of claim 1, further comprising a slow pumping pipeline, a first on-off valve, and a flow limiting device, wherein a first end of the slow pumping pipeline is communicated with the first vacuum pipeline, a second end of the slow pumping pipeline is communicated with the second vacuum pipeline, and the flow limiting device and the first on-off valve are both disposed on the slow pumping pipeline.

3. The exhaust system of claim 2, wherein the flow limiting device comprises a first restrictor and a throttle valve.

4. The exhaust system of claim 1, further comprising a first pressure relief pipe, a second pressure relief pipe, and a second on-off valve, wherein an inlet end of the first pressure relief pipe is communicated with the first vacuum pipeline, an outlet end of the first pressure relief pipe is communicated with the second pressure relief pipe, and the second on-off valve is disposed between the first pressure relief pipe and the second pressure relief pipe.

5. The exhaust system of claim 4, further comprising a third pressure relief pipe and a third on-off valve, wherein an inlet end of the third pressure relief pipe is communicated with the first vacuum pipeline, an outlet end of the third pressure relief pipe is communicated with the second pressure relief pipe, and the third on-off valve is disposed on the third pressure relief pipe.

6. The exhaust system of claim 4, further comprising a first check valve, which is disposed on the second pressure relief pipe, and conducts the second pressure relief pipe along a direction from an inlet end of the second pressure relief pipe to an outlet end of the second pressure relief pipe.

7. The exhaust system of claim 4, further comprising a first supplementary gas pipeline and a fourth on-off valve, wherein an inlet end of the first supplementary gas pipeline is configured to introduce a purge gas, an outlet end of the first supplementary gas pipeline is communicated with the second pressure relief pipe to enable the purge gas to blow the second pressure relief pipe, and the fourth on-off valve is disposed on the first supplementary gas pipeline, and controls on or off of the first supplementary gas pipeline.

8. The exhaust system of claim 7, further comprising at least one of a pressure regulating valve or a flow regulating element, wherein the at least one of the pressure regulating valve or the flow regulating element is disposed on the first supplementary gas pipeline.

9. The exhaust system of claim 7, further comprising a second check valve, which is disposed on the first supplementary gas pipeline, and conducts the first supplementary gas pipeline along a direction from the inlet end of the first supplementary gas pipeline to the outlet end of the first supplementary gas pipeline.

10. The exhaust system of any one of claims 1 to 9, further comprising a second supplementary gas pipeline, a fifth on-off valve, and a second pressure detection device, wherein an inlet end of the second supplementary gas pipeline is configured to introduce a gas, an outlet end of the second supplementary gas pipeline is communicated with the second vacuum pipeline, the fifth on-off valve is disposed on the second supplementary gas pipeline, the second pressure detection device is disposed on the second vacuum pipeline to detect a pressure value of the second vacuum pipeline, and a state of the fifth on-off valve changes based on the pressure value detected by the second pressure detection device.

11. The exhaust system of claim 10, further comprising a second restrictor, which is disposed on the second supplementary gas pipeline; and/or, a third check valve, which is disposed on the second supplementary gas pipeline, and conducts the second supplementary gas pipeline along a direction from the inlet end of the second supplementary gas pipeline to the outlet end of the second supplementary gas pipeline.

12. The exhaust system of any one of claims 1 to 9, further comprising a sixth on-off valve, which has an inlet end configured to be connected to a first seal detection device and an outlet end connected to the first vacuum pipeline; and/or
a seventh on-off valve, which has an inlet end configured to be connected to a second seal detection device, and an outlet end connected to the second vacuum pipeline.

13. The exhaust system of any one of claims 1 to 9, wherein the first pressure detection device comprises a first vacuum gauge and a second vacuum gauge, a range of the first vacuum gauge being narrower than a range of the second vacuum gauge;
the exhaust system further comprises a first branch, a second branch, and an eighth on-off valve, a first end of the first branch and a first end of the second branch are both communicated with the first vacuum pipeline, a second end of the first branch is connected to the first vacuum gauge, the eighth on-off valve is disposed on the first branch, and a second end of the second branch is connected to the second vacuum gauge; and
in a case where a pressure value detected by the second vacuum gauge is greater than a second pressure value, the eighth on-off valve is in a closed state; and in a case where the pressure value detected by the second vacuum gauge is less than or equal to the second pressure value, the eighth on-off valve is in an open state.

14. The exhaust system of claim 13, wherein the first pressure detection device further comprises a differential pressure gauge, the exhaust system further comprises a third branch and a ninth on-off valve, a first end of the third branch is communicated with the first vacuum pipeline, a second end of the third branch is connected to a first end of the differential pressure gauge, a second end of the differential pressure gauge is communicated with the external atmosphere, and the ninth on-off valve is disposed on the third branch; and
in a case where a difference between the pressure value detected by the second vacuum gauge and an atmospheric pressure value is less than a first difference, the ninth on-off valve is in an open state.

15. A semiconductor process apparatus, comprising a reaction chamber and the exhaust system of any one of claims 1 to 14, wherein the inlet end of the first vacuum pipeline is communicated with the reaction chamber.
